# EUROPEAN PATENT APPLICATION

(11) **EP 1 560 006 A1**
(43) Date of publication of application: **03.08.2005**
(21) Application number: 03809454.6
(22) Date of filing: 23.10.2003
(51) Int. Cl.: G01J 1/04, G01J 1/02, G01J 3/36, G02B 5/04, G02B 5/26, H01L 27/14

(54) **OPTICAL UNIT, OPTICAL SENSOR, MULTICHANNEL OPTICAL SENSING APPARATUS, AND METHOD FOR MANUFACTURING OPTICAL UNIT**

(30) Priority: 25.10.2002 JP 2002311727
(71) Applicant: ARKRAY, Inc., Kyoto-shi, Kyoto 601-8045 (JP)
(72) Inventor: MURAKAMI, Atsushi, ARKRAY, INC., Kyoto-shi, Kyoto 601-8045 (JP); FURUSATO, Noriaki, ARKRAY, INC., Kyoto-shi, Kyoto 601-8045 (JP)
(74) Representative: Power, Philippa Louise
(86) International application number: PCT/JP2003/013518
(87) International publication number: WO 2004/038348

(57) **Abstract**

An optical unit is composed of transparent blocks and dichroic films that are different in wavelength range of a reflectible light beam. The transparent blocks are connected in a row so that the dichroic films may be interposed between the respective transparent blocks, and may be in parallel to each other.

## Description

### TECHNICAL FIELD

The present invention relates to an optical unit, an optical sensor, a multichannel photodetector, and a method for manufacturing the optical unit.

### BACKGROUND ART

Recently, various analyses and measurements are conducted by detecting reflected light beams, fluorescence and the like from objects. For example, when measuring infrared ray absorbance of an object so as to analyze material properties of the object, light beams reflected by the object are detected. Also, when measuring a degree of light absorption by a specific component of a sample so as to analyze an object qualitatively or quantitatively, light beams reflected by the object are detected. Moreover, in a genetic diagnosis, fluorescence excited by light beams emitted by a light source is detected so as to analyze genes amplified by gene amplification.

In such analyses and measurements, photodetectors that can detect light beams with various wavelengths are used. Generally, the photodetector is provided with an optical sensor, as disclosed in, for example, JP 5(1993)-322653 A and JP 5(1993)-240700 A, and the optical sensor is composed of a filter for obtaining a light beam with a target wavelength from incident light beams, and a photoreceptor, such as a photodiode, for receiving the obtained light beam and transforming the received light beam into an electric signal.

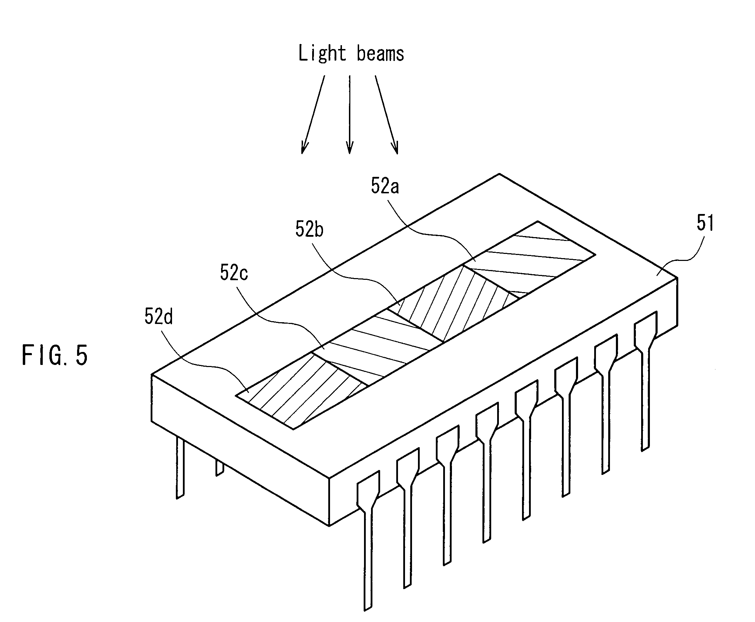

FIG. 5 is a perspective view showing an optical sensor used in a conventional photodetector. As shown in FIG. 5, an optical sensor 51 is a photoreceptor including a plurality of photoreceptive surfaces 52a to 52d. In addition, in an example of FIG. 5, the optical sensor 51 is a CCD (charge coupled device). On the respective photoreceptive surfaces 52a to 52d of the optical sensor 51, filters of different transmission wavelength are provided.

Accordingly, when the optical sensor 51 is irradiated with light beams as shown in FIG. 5, each of the irradiation light beams passes through any of the filters according to a wavelength thereof, and is incident upon any of the photoreceptive surfaces 52a to 52d, so that the optical sensor 51 outputs a signal corresponding to the wavelength of the irradiation light beam. Based on this output signal, various kinds of analyses including a wavelength distribution analysis are conducted.

By the way, in the above-mentioned optical sensor shown in FIG. 5, the plurality of photoreceptive surfaces are arranged two-dimensionally. Thus, in order to improve the accuracy of detection, it is necessary to irradiate all of the photoreceptive surfaces 52a to 52d with light beams uniformly.

However, in order to irradiate the respective photoreceptive surfaces with light beams uniformly, it is necessary to increase the overall size of the photodetector in which the optical sensor is used. In addition, there is a high possibility that light amounts of the light beams incident upon the respective photoreceptive surfaces are not uniform, for example, a light amount around a certain photoreceptive surface decreases, depending on a position of the optical sensor during the irradiation with the light beams. Therefore, it is difficult to improve the accuracy of detection of the above-mentioned optical sensor shown in FIG. 5.

The object of the present invention is to solve the above-described problems, and to provide an optical unit that can disperse incident light beams with high accuracy according to wavelengths thereof, and a method for manufacturing the optical unit. Furthermore, the object of the present invention is to provide an optical sensor and a multichannel photodetector using this optical unit.

### DISCLOSURE OF THE INVENTION

In order to attain the above-mentioned object, the optical unit according to the present invention is an optical unit, including: a plurality of transparent blocks; and a plurality of dichroic films that are different in wavelength range of a reflectible light beam, wherein the plurality of transparent blocks are connected in a row so that any of the plurality of dichroic films may be interposed between the respective transparent blocks, and the plurality of dichroic films may be in parallel to each other.

The above-mentioned optical unit according to the present invention may have an embodiment in which the plurality of dichroic films have characteristics of reflecting only light beams with certain wavelengths or longer, and are arranged in order of minimum wavelength of the reflectible light beam. Alternatively, the optical unit may have an embodiment in which the plurality of dichroic films have characteristics of reflecting only light beams with certain wavelengths or shorter, and are arranged in order of maximum wavelength of the reflectible light beam. Furthermore, the optical unit may have an embodiment in which a total reflection film, instead of the dichroic film, is interposed between the transparent block at one end of the row of the plurality of transparent blocks and the transparent block connected to the transparent block at the end of the row.

Next, in order to attain the above-mentioned object, the optical sensor according to the present invention is an optical sensor, including: an optical unit which includes a plurality of transparent blocks and a plurality of dichroic films that are different in wavelength range of a reflectible light beam; and a photoreceptor that includes a plurality of photoreceptive surfaces arranged in a row, wherein the plurality of transparent blocks are connected in a row so that the plurality of dichroic films may be in parallel to each other, and any of the plurality of dichroic films may be interposed between the respective transparent blocks, and the optical unit is disposed so that a light beam incident from the transparent block at one end of the row of the plurality of transparent blocks may be reflected by any of the plurality of dichroic films and may be incident upon any of the plurality of photoreceptive surfaces.

Moreover, in order to attain the above-mentioned object, the multichannel photodetector according to the present invention is a multichannel photodetector, including at least a reaction container, a plurality of light emitting devices that are different in wavelength of an emitted light beam, a first optical unit, a second optical unit and a plurality of photoreceptors, wherein the plurality of light emitting devices are arranged in order of wavelength of the emitted light beam so that output directions of the respective light emitting devices may be in parallel, the plurality of photoreceptors are arranged so that photoreceptive surfaces of the respective photoreceptors may be in parallel, the first optical unit and the second optical unit respectively include a plurality of transparent blocks and a plurality of dichroic films that are different in wavelength range of a reflectible light beam, the plurality of transparent blocks are connected in a row so that the plurality of dichroic films may be in parallel to each other and any of the plurality of dichroic films may be interposed between the respective transparent blocks, the first optical unit is disposed so that each of the light beams emitted by the plurality of light emitting devices may be reflected by any of the plurality of dichroic films according to the wavelength of the emitted light beam, and may be output from the first optical unit along the same optical path, and the second optical unit is disposed so that each of light beams output from an inside of the reaction container may be reflected by any of the plurality of dichroic films and may be incident upon any of the plurality of photoreceptors according to a wavelength of the light beam.

In order to attain the above-mentioned object, the method for manufacturing an optical unit according to the present invention is a method for manufacturing an optical unit that includes at least a plurality of transparent blocks and a plurality of dichroic films that are different in wavelength range of a reflectible light beam, including at least the steps of:
(a) providing the dichroic film on one flat surface of a first transparent member that includes at least the one flat surface; (b) connecting a second transparent member including at least two parallel flat surfaces to the dichroic film so that one of the two flat surfaces may face the dichroic film, and the other one of the two flat surfaces may be provided with another dichroic film different from the dichroic film; (c) connecting another first transparent member different from the first transparent member to the another dichroic film that is positioned as a top layer by one flat surface of the another first transparent member; (d) cutting a connected body obtained by the steps (a) to (c) along: a first plane that intersects the one flat surface of the first transparent member, the one flat surface of the another first transparent member and the two flat surfaces of the plurality of second transparent members; and a second plane that is parallel to the first plane.

The method for manufacturing an optical unit according to the present invention may include the step of connecting a second transparent member which includes at least two parallel flat surfaces to the dichroic film so that one of the two flat surfaces may face the dichroic film, and providing another dichroic film different from the dichroic film to the other one of the two flat surfaces, instead of the step (b). Moreover, the method for manufacturing an optical unit may include providing a total reflection film instead of the dichroic film in the step of (a), alternatively, providing a total reflection film instead of the another dichroic film that is positioned as the top layer in the step of (b).

### BRIEF DESCRIPTION OF DRAWINGS

FIG. 1 is a perspective view showing an example of a method for manufacturing the optical unit according to the present invention, and FIGs. 1A to 1D show main manufacturing processes.
FIG. 2 is a view showing an example of the optical unit according to the present invention obtained by the manufacturing method shown in FIG. 1, FIG. 2A shows a case where light beams with different wavelengths are incident along the same optical path, and FIG. 2B shows a case where light beams with different wavelengths are incident along different optical paths.
FIG. 3 is a perspective view showing an example of the optical sensor according to the present invention.
FIG. 4 is a perspective view schematically showing an inner structure of an example of the multichannel photodetector according to the present invention.
FIG. 5 is a perspective view showing an optical sensor used in a conventional photodetector.

### BEST MODE FOR CARRYING OUT THE INVENTION

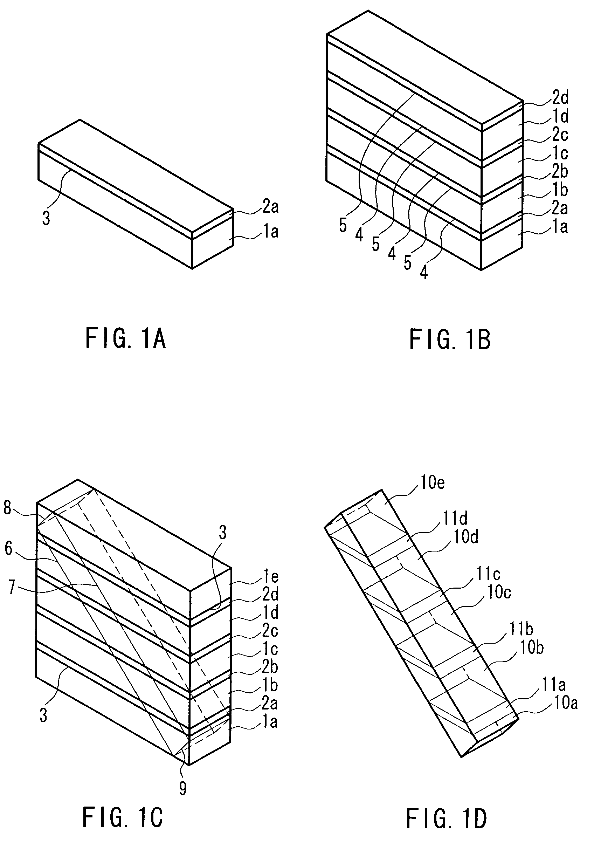

The optical unit, the optical sensor and the multichannel photodetector of the present invention, and a method for manufacturing the optical unit will be described below with reference to FIGs. 1 to 4.

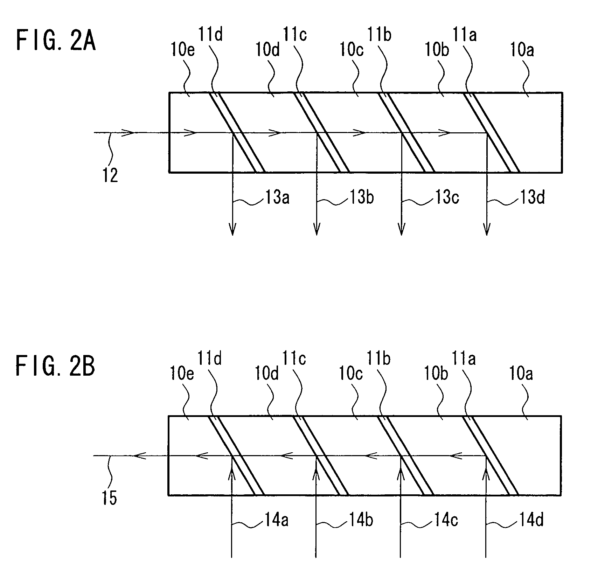

First, the optical unit of the present invention and a method for manufacturing the optical unit will be described with reference to FIGs. 1 and 2. The optical unit of the present invention includes at least a plurality of transparent blocks and a plurality of dichroic films that are different in wavelength range of a reflectible light beam, which is produced according to the manufacturing processes shown in FIG. 1.

FIG. 1 is a perspective view showing an example of a method for manufacturing the optical unit according to the present invention, and FIGs. 1A to 1D show main manufacturing processes. FIG. 2 is a view showing an example of the optical unit according to the present invention obtained by the manufacturing method shown in FIG. 1, FIG. 2A shows a case where light beams with different wavelengths are incident along the same optical path, and FIG. 2B shows a case where light beams with different wavelengths are incident along different optical paths.

First, as shown in FIG. 1A, a dichroic film 2a is provided on a flat surface 3 of a transparent member 1a. Next, as shown in FIG. 1B, transparent members 1b to 1d are connected sequentially to the dichroic film 2a so that flat surfaces 4 of the respective transparent members may face the dichroic film 2a, and flat surfaces 5 of the respective transparent members may be provided with dichroic films 2b to 2d respectively. Moreover, as shown in FIG. 1C, a transparent member 1e is connected to the dichroic film 2d that is positioned as a top layer on a flat surface 3 of the transparent member 1e.

In the example of FIG. 1, the transparent members 1a to 1e are rectangular-parallelepiped-shaped and have six flat surfaces. However, the present invention is not limited to this, and each of the transparent members 1a and 1e may have any shape with at least one flat surface thereon, because each of the transparent members 1a and 1e is provided with a dichroic film on only one surface thereof. Moreover, each of the transparent members 1b to 1d may have at least two parallel flat surfaces, because each of the transparent members 1b to 1d is provided with dichroic films on two surfaces thereof facing to each other.

In the present invention, materials composing the transparent members may be, for example, polymeric materials for optical elements, which are represented by PMMA (polymethyl methacrylate) and PC (polycarbonate), and optical glass.

In the example of FIG. 1, the dichroic films 2a to 2d have characteristics of reflecting only light beams with certain wavelengths or longer (low-pass characteristics), and minimum wavelengths of reflectible light beams of the respective dichroic films 2a to 2d increase in this order. Alternatively, the minimum wavelengths of the reflectible light beams of the respective dichroic films 2a to 2d may decrease in this order.

Also, the dichroic films 2a to 2d may have characteristics of reflecting only light beams with certain wavelengths or shorter (high-pass characteristics). In this case, maximum wavelengths of the reflectible light beams of the respective dichroic films 2a to 2d may increase or decrease in this order.

In the example of FIG. 1, the dichroic films 2b to 2d are formed on the flat surfaces 5 of the respective transparent members 1b to 1d, before connecting the transparent members 1b to 1d. In addition, the formation of the dichroic films 2b to 2d on the transparent members 1b to 1d may be conducted at the time of the formation of the dichroic film 2a on the transparent member 1a. Alternatively, the dichroic films 2b to 2d may be formed each time when the transparent members 1b to 1d are connected respectively.

Here, the dichroic films 2a to 2d preferably are formed so that the film thicknesses thereof may be uniform. This is because, by forming the dichroic films 2a to 2d with the uniform film thicknesses, the flat surfaces 3 to 5 of the transparent members 1a to 1e may be in parallel, whereby reflection directions of the reflected light beams may be the same, as shown in FIGs. 2A and 2B described below.

In the present invention, a total reflection film may be disposed instead of the dichroic film 2d as a top layer or the dichroic film 2a as a bottom layer. In this case, the total reflection film may be formed by evaporating a thin film of aluminum or the like.

Moreover, the number of the dichroic films is four in the example of FIG. 1, but the present invention is not limited to this. The number of the dichroic films may be set as appropriate, according to the use or the like of the optical unit of the present invention. Also, the number of the transparent members may be set so as to correspond to the number of the dichroic films.

Next, as shown in FIG. 1D, a connected body obtained by the processes of FIGs. 1A to 1C is cut along a first plane 6, a second plane 7, a third plane 8 and a fourth plane 9 that are shown in FIG. 1C. Thereby, the optical unit of the present invention can be obtained.

The first plane 6 is a plane intersecting the flat surfaces 3 to 5 of the transparent members 1a to 1d. Therefore, the optical unit includes all of the dichroic films 2a to 2d, as shown in FIG. 1C. Furthermore, in the example of FIG. 1, the first plane 6 is a plane perpendicular to a side face of the connected body.

In addition, the second plane 7 is parallel to the first plane 6. By setting a distance between the second plane 7 and the first plane 6 as appropriate, the thickness of the optical unit can be determined. The third plane 8 and the fourth plane 9 intersect both of the first plane 6 and the second plane 7 perpendicularly. Here, if ends of the optical unit are processed to be rounded off or the like, it is not necessary to cut along the third plane 8 and the fourth plane 9.

A method for cutting the connected body may be cutting with a diamond cutter or the like, but is not limited particularly. Cut surfaces of the connected body preferably are polished as necessary. Moreover, in the thus obtained optical unit, surfaces except an incident surface and an output surface for light beams preferably are shaded or the like, for obtaining higher utility of the light beams.

As mentioned above, according to the above-described processes of FIGs. 1A to 1D, the optical unit having the transparent blocks 10a to 10e and the dichroic films 11a to 11d that are different in wavelength range of the reflectible light beam can be obtained, as shown in FIG. 1D.

In this optical unit, the transparent blocks 10a to 10e are connected in a row so that any of the dichroic films 11a to 11d may be interposed between the respective transparent blocks. In addition, as mentioned above, the dichroic films 11a to 11d are provided between the transparent blocks in order of minimum wavelength of the reflectible light beam. Thus, as shown in FIG. 2A, when a light beam 12 enters from one end of the row of the transparent blocks, the light beam 12 is reflected by any of the dichroic films 11a to 11d, according to a wavelength thereof.

By the way, it generally depends on an angle for installing a dichroic film whether a light beam with a set wavelength can be reflected by the dichroic film accurately or not. Accordingly, all of inclination angles of connection faces of the respective transparent blocks for disposing the dichroic films thereon are preferably equal so that light beams incident along the same optical path as shown in FIG. 2A may be reflected by any of the dichroic films accurately, according to the wavelength of the light beam.

Whereas, in the optical unit of the present invention, connection faces of the transparent blocks 10a to 10e are part of the flat surfaces 3 to 5 of the transparent members 1a to 1d as shown in FIG. 1, and are parallel to each other. Thus, the dichroic films 11a to 11d are parallel to each other. As a result, according to the method for manufacturing the optical unit of the present invention shown in FIG. 1, angles for installing the dichroic films 11a to 11d with respect to an incident direction of the light beams can be set to be equal with high accuracy. Moreover, by setting a cutting direction as appropriate in the process of FIG. 1D, the angles for installing the dichroic films 11a to 11d with respect to the incident direction of the light beams can be set easily.

Thus, as shown in FIG. 2A, the method for manufacturing the optical unit of the present invention can realize an optical unit that is capable of outputting, in the same direction, all of light beams 13a to 13d reflected by the dichroic films. Furthermore, in the optical unit obtained by the processes shown in FIG. 1, when light beams 14a to 14d with different wavelengths are incident upon the respective dichroic films 11a to 11d in parallel, the light beams are output along the same optical path, as shown in FIG. 2B. Here, reference numeral 15 denotes the output light beam.

In addition, in the optical unit of the present invention, the dichroic films 11a to 11d are unified by the transparent blocks 10a to 10e. Thus, according to the optical unit of the present invention, unlike the case of composing an optical system of a plurality of dichroic mirrors, it is not necessary to adjust the angles for installing the respective dichroic films individually, and incident light beams can be dispersed according to wavelengths thereof with high accuracy, only by determining a position of the whole optical unit.

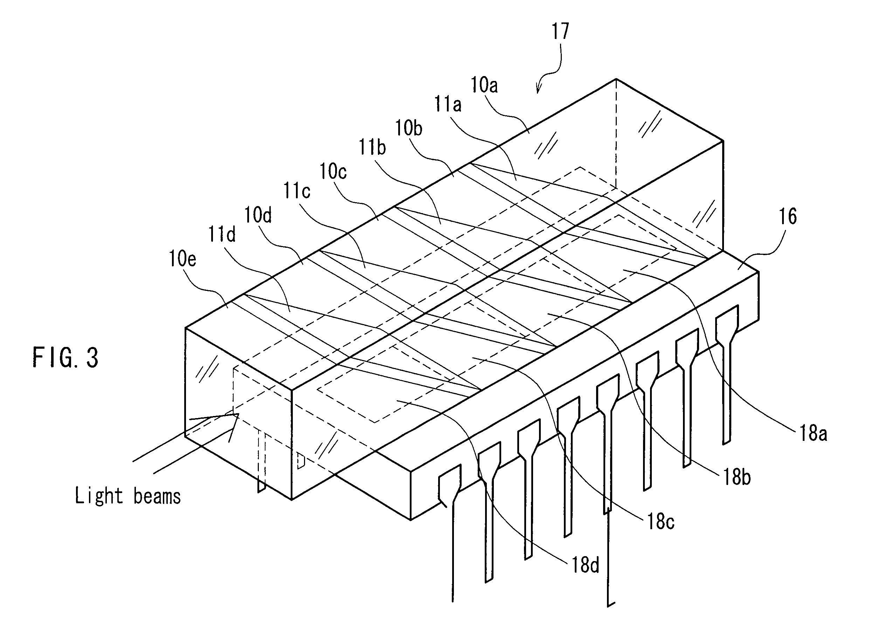

Next, the optical sensor of the present invention will be described with reference to FIG. 3. FIG. 3 is a perspective view showing an example of the optical sensor according to the present invention. As shown in FIG. 3, the optical sensor of the present invention is composed of a photoreceptor 16 and an optical unit 17. In the example of FIG. 3, the photoreceptor 16 is a CCD including photoreceptive surfaces 18a to 18d that are arranged in a row. The optical unit 17 is the optical unit shown in FIGs. 1D and 2.

Moreover, as shown in FIG. 3, the optical unit 17 is disposed so that each of light beams incident from the transparent block 10a disposed at one end of the row of the transparent blocks may be reflected by any of the dichroic films 11a to 11d, and may be incident upon any of the photoreceptive surfaces 18a to 18d. Accordingly, in the optical sensor of the present invention, when irradiating the end of the optical unit 17 with light beams, each of the irradiation light beams is incident upon any of the photoreceptive surfaces 18a to 18d, according to a wavelength of the irradiation light beam.

As mentioned above, according to the optical sensor of the present invention, the optical unit 18 can uniformize the light beams incident upon the respective photoreceptive surfaces without uniform irradiation of the whole photoreceptive surfaces of the photoreceptor 16 with the light beams, whereby higher accuracy of detection can be obtained, compared with the conventional optical sensor. Moreover, in the optical sensor of the present invention, since the irradiation light beams may be led into the optical unit 17 using optical fibers or the like, loss of the irradiation light beams may be suppressed more, compared with the conventional optical sensor. Furthermore, if composing a photodetector using the optical sensor of the present invention, the photodetector can be decreased in size.

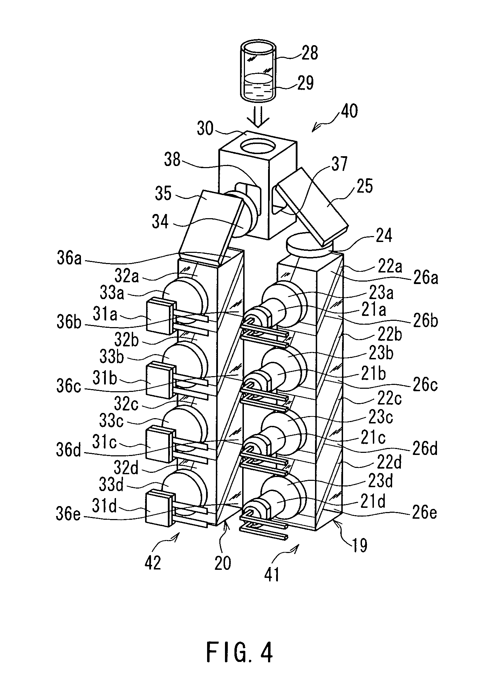

Next, the multichannel photodetector of the present invention will be described with reference to FIG. 4. FIG. 4 is a perspective view schematically showing an inner structure of an example of the multichannel photodetector according to the present invention.

As shown in FIG. 4, the multichannel photodetector is an apparatus used for genetic diagnoses, and includes a reaction container 40, a light source unit 41 and a photoreceptive unit 42. The reaction container 40 is composed of a transparent vessel 28 and a storage case 30 for storing the transparent vessel 28. In the transparent vessel 28, a mixture 29 containing a sample as a target of a genetic diagnosis, reagents, fluorochrome and the like is added.

In addition, the storage case 30 is provided with a heating means (not shown in the figure) such as a heater for performing gene amplification that is represented by, for example, a PCR method. Thus, when genes are amplified by being subjected to the gene amplification, the fluorochrome is excited by light beams emitted by the light source unit 41 to the reaction container 40, and then light beams are output from an inside of the reaction container 40. The thus output light beams are received by the photoreceptive unit 42.

Moreover, the storage case 30 is provided with an entrance window 37 for allowing light beams emitted by the light source unit 41 to enter an inside of the transparent vessel 28, and an output window 38 for releasing light beams that are output from the inside of the transparent vessel 28 toward outside.

The light source unit 41 includes light emitting devices 21a to 21d and an optical unit 19. The light emitting devices 21a to 21d are different in wavelength of an emitted light beam, and the wavelengths of the emitted light beams by the respective light emitting devices 21a, 21b, 21c and 21d increase in this order. In addition, the light emitting devices 21a to 21d are arranged so that output directions of the respective light emitting devices may be in parallel.

The optical unit 19 is produced by the manufacturing method shown in FIGs. 1A to 1D, and is composed of the transparent blocks 26a to 26e and the dichroic films 22a to 22d that are different in wavelength range of a reflectible light beam. Here, in the optical unit 19, the dichroic films 22a to 22d have characteristics of reflecting only light beams with certain wavelengths or shorter (high-pass characteristics), and maximum wavelengths of the reflectible light beams of the respective dichroic films 22a to 22d increase in this order. In addition, the maximum wavelengths of the reflectible light beams of the dichroic films 22a to 22d may be determined according to the wavelengths of the light beams emitted by the light emitting devices 21a to 21d.

Moreover, the optical unit 19 is disposed so that a long axis thereof may be perpendicular to output directions of the light emitting devices 21a to 21d. Thus, the emitted light beams by the light emitting devices 21a to 21d are reflected in the same direction by the dichroic films 22a to 22d according to the wavelengths of the emitted light beams, and are output from the optical unit 19 along the same optical path, as shown in FIG. 2B. That is, according to the light source unit 41, a plurality of light beams with different wavelengths can be output along the same optical path and can enter the reaction container 40.

In the light source unit 41 shown in FIG. 4, the number of the light emitting devices is not limited to the above-mentioned example. The number of the light emitting devices is determined according to the number of kinds of fluorochrome that are used for a genetic diagnosis. Moreover, in the light source unit 41 shown in FIG. 4, the wavelengths of the light beams emitted by the light emitting devices are determined according to excitation peak wavelengths of the kinds of fluorochrome used in the genetic diagnosis. Therefore, the light emitting devices are selected according to the required wavelengths. Light emitting diodes or semiconductor lasers are used as the light emitting devices.

The photoreceptive unit 42 includes photoreceptors 31a to 31d and an optical unit 20. Each of the photoreceptors 31a to 31d is provided with one photoreceptive surface (not shown in the figure), and is disposed so that the respective photoreceptive surfaces may be in parallel.

The optical unit 20 also is produced by the manufacturing method shown in FIGs. 1A to 1D, and is composed of the transparent blocks 36a to 36e and the dichroic films 32a to 32d that are different in wavelength range of a reflectible light beam. Moreover, also in the optical unit 20, the dichroic films 32a to 32d have characteristics of reflecting only light beams with certain wavelengths or longer (low-pass characteristics), similarly to the optical unit shown in FIG. 1D, and minimum wavelengths of the reflectible light beams of the respective dichroic films 32a to 32d increase in order of the dichroic films 32d, 32c, 32b and 32a. In addition, the minimum wavelengths of the reflectible light beams of the dichroic films 32a to 32d are set according to the kinds of fluorochrome used in the genetic diagnosis.

Moreover, the optical unit 20 is disposed so that a long axis thereof may be perpendicular to normal lines of the photoreceptive surfaces of the photoreceptors 31a to 31d. Thus, when the light beam output from the inside of the reaction container 40 is incident upon the optical unit 20, the incident light beam is reflected by any of the dichroic films 32a to 32d and is incident upon the photoreceptive surfaces of a corresponding one of the photoreceptors 31a to 31d, according to a wavelength of the incident light beam, as shown in FIG. 2A. That is, according to the photoreceptive unit 42, a plurality of light beams with different wavelengths that are incident along the same optical path can be incident upon the respective photoreceptors.

In FIG. 4, reference numerals 23a to 23d denote lenses for condensing the light beams emitted by the light emitting devices 21a to 21d. Reference numeral 24 denotes a lens for condensing the light beams emitted by the light source unit 41. Reference numeral 25 is a total reflection mirror for leading the light beams emitted by the light source unit 41 to the entrance window 37 of the reaction container 40.

Moreover, in FIG. 4, reference numerals 33a to 33d denote lenses for condensing the light beams reflected by the dichroic films 32a to 32d. Reference numeral 34 denotes a lens for condensing the light beams output from the inside of the reaction container 40 via the output window 38. Reference numeral 35 is a total reflection mirror for leading the light beams output from the inside of the reaction container to the optical unit 20.

As mentioned above, the multichannel photodetector of the present invention can emit light beams corresponding to the kinds of fluorochrome contained in a sample, and can analyze the excited fluorescence. In addition, the multichannel photodetector of the present invention includes the optical unit of the present invention. Therefore, since it is easy to equalize all of the reflection angles of the respective dichroic films in the light source unit and the photoreceptive unit, high accuracy of detection can be obtained by using the multichannel photodetector of the present invention.

### INDUSTRIAL APPLICABILITY

As mentioned above, according to the optical unit of the present invention and the method for manufacturing the optical unit, an optical unit in which dichroic films easily can reflect light beams with certain wavelengths with high accuracy can be obtained. In addition, the optical sensor of the present invention can perform detection without uniform irradiation of whole photoreceptive surfaces of photoreceptors with light beams, and can have a compact structure to be decreased in size. Furthermore, the multichannel photodetector of the present invention can provide high accuracy of detection.

## Claims

1. An optical unit, comprising: a plurality of transparent blocks; and a plurality of dichroic films that are different in wavelength range of a reflectible light beam,
wherein the plurality of transparent blocks are connected in a row so that any of the plurality of dichroic films may be interposed between the respective transparent blocks, and the plurality of dichroic films may be in parallel to each other.

2. The optical unit according to Claim 1, wherein the plurality of dichroic films have characteristics of reflecting only light beams with certain wavelengths or longer, and are arranged in order of minimum wavelength of the reflectible light beam.

3. The optical unit according to Claim 1, wherein the plurality of dichroic films have characteristics of reflecting only light beams with certain wavelengths or shorter, and are arranged in order of maximum wavelength of the reflectible light beam.

4. The optical unit according to Claim 1, wherein a total reflection film, instead of the dichroic film, is interposed between the transparent block at one end of the row of the plurality of transparent blocks and the transparent block connected to the transparent block at the end of the row.

5. An optical sensor, comprising: an optical unit which comprises a plurality of transparent blocks and a plurality of dichroic films that are different in wavelength range of a reflectible light beam; and a photoreceptor that comprises a plurality of photoreceptive surfaces arranged in a row,
wherein the plurality of transparent blocks are connected in a row so that the plurality of dichroic films may be in parallel to each other, and any of the plurality of dichroic films may be interposed between the respective transparent blocks, and
the optical unit is disposed so that a light beam incident from the transparent block disposed at one end of the row of the plurality of transparent blocks may be reflected by any of the plurality of dichroic films and may be incident upon any of the plurality of photoreceptive surfaces.

6. A multichannel photodetector, comprising at least a reaction container, a plurality of light emitting devices that are different in wavelength of an emitted light beam, a first optical unit, a second optical unit and a plurality of photoreceptors,
wherein the plurality of light emitting devices are arranged in order of wavelength of the emitted light beam so that output directions of the respective light emitting devices may be in parallel,
the plurality of photoreceptors are arranged so that photoreceptive surfaces of the respective photoreceptors may be in parallel,
the first optical unit and the second optical unit respectively comprise a plurality of transparent blocks and a plurality of dichroic films that are different in wavelength range of a reflectible light beam, the plurality of transparent blocks are connected in a row so that the plurality of dichroic films may be in parallel to each other and any of the plurality of dichroic films may be interposed between the respective transparent blocks,
the first optical unit is disposed so that each of the light beams emitted by the plurality of light emitting devices may be reflected by any of the plurality of dichroic films according to the wavelength of the emitted light beam, and may be output from the first optical unit along the same optical path, and
the second optical unit is disposed so that each of light beams output from an inside of the reaction container may be reflected by any of the plurality of dichroic films and may be incident upon any of the plurality of photoreceptors according to a wavelength of the light beam.

7. A method for manufacturing an optical unit that comprises at least a plurality of transparent blocks and a plurality of dichroic films that are different in wavelength range of a reflectible light beam, comprising at least the steps of:
(a) providing the dichroic film on one flat surface of a first transparent member that comprises at least the one flat surface;
(b) connecting a second transparent member including at least two parallel flat surfaces to the dichroic film so that one of the two flat surfaces may face the dichroic film, and the other one of the two flat surfaces may be provided with another dichroic film different from the dichroic film;
(c) connecting another first transparent member different from the first transparent member to the another dichroic film that is positioned as a top layer by one flat surface of the another first transparent member;
(d) cutting a connected body obtained by the steps (a) to (c) along: a first plane that intersects the one flat surface of the first transparent member, the one flat surface of the another first transparent member and the two flat surfaces of the plurality of second transparent members; and a second plane that is parallel to the first plane.

8. The method for manufacturing an optical unit according to Claim 7, comprising the step of connecting a second transparent member which comprises at least two parallel flat surfaces to the dichroic film so that one of the two flat surfaces may face the dichroic film, and providing another dichroic film different from the dichroic film to the other one of the two flat surfaces, instead of the step (b).

9. The method for manufacturing an optical unit according to Claim 7, comprising providing a total reflection film instead of the dichroic film in the step of (a), alternatively, providing a total reflection film instead of the another dichroic film that is positioned as the top layer in the step of (b).
